# EUROPEAN PATENT SPECIFICATION

(11) **EP 3 356 251 B1**
(45) Date of publication and mention of the grant of the patent: **02.09.2020**
(21) Application number: 15905101.0
(22) Date of filing: 30.09.2015
(51) Int. Cl.: B65D 65/40, C08J 7/04, C08L 41/00

(54) **MULTILAYER BARRIER STACK**
MEHRSCHICHTIGER BARRIERESTAPEL
EMPILEMENT BARRIÈRE MULTICOUCHE

(43) Date of publication of application: 08.08.2018
(73) Proprietor: 3M Innovative Properties Company, St. Paul, MN 55133-3427 (US)
(72) Inventor: CHEN, Xue-hua, Shanghai 200336 (CN); DAVID, Moses M., Saint Paul, Minnesota 55133-3427 (US); QIU, Zai-Ming, Saint Paul, Minnesota 55133-3427 (US); LACHMANSINGH, Garry W., Saint Paul, Minnesota 55133-3427 (US); KOLB, William B., Saint Paul, Minnesota 55133-3427 (US); MACKEY, Sonja S., Saint Paul, Minnesota 55133-3427 (US); SHENG, Xiaohai, Shanghai 200336 (CN); JING, Naiyong, Saint Paul, Minnesota 55133-3427 (US); POKORNY, Richard J., Saint Paul, Minnesota 55133-3427 (US); LYONS, Christopher S., Saint Paul, Minnesota 55133-3427 (US); LI, Yongjie, Shanghai 200336 (CN)
(74) Representative: Mathys & Squire
(86) International application number: PCT/CN2015/091279
(87) International publication number: WO 2017/054189

(56) References cited:
- CN-A- 1 204 293
- CN-A- 1 953 876
- CN-A- 103 647 029
- JP-A- 2001 096 677
- US-A1- 2009 253 805
- US-A1- 2009 253 805
- DATABASE WPI Week 198733 Thomson Scientific, London, GB; AN 1987-232384 XP002788417, & JP S62 156939 A (TOYOBO KK) 11 July 1987 (1987-07-11)

## Description

### TECHNICAL FIELD

The present disclosure relates to multilayer barrier stacks or films including a smooth layer and a barrier layer.

### BACKGROUND

A wide range of products from food package, medical package, electronic package, solar cell to display require protection from oxygen and/or water ingress and protection from scratching. Banner coatings or films have been developed to protect such products. Available barrier coatings or films generally are a stack of continuous layers including a substrate and a barrier film overlaying the substrate, where the substrate and barrier film as a whole can provide protection for the products.

US 2009/253805 A1 relates to a barrier material for use in the packaging of various products comprising a product prepared from a photopolymerizable formulation comprising a multifunctional thiol, a multifunctional-ene monomer, and optionally a photoinitiator applied to a substrate comprising polycaprolactone, polyethylene terephthalate, polypropylene, or polyethylene; and curing the formulation with UV light.

### SUMMARY

Briefly, in one aspect, the present disclosure describes a multilayer barrier film including a layer having a smooth surface, and a barrier layer directly disposed on the surface of the smooth layer. The smooth layer includes a thiol-ene material as a polymeric matrix material, wherein the smooth layer further comprises particles having an average dimension in the range of 2 nm to 2 micron hosted by the polymeric matrix material, and
wherein the thio-ene material is formed by curing one or more polythiol monomers with one or more polyene monomers In some cases, the thiol-ene material includes a cured thiol-ene resin having a glass transition temperature (Tg) > 20°C.

In another aspect, the present disclosure describes a multilayer barrier film including a substrate having a first major surface and a second major surface opposite the first major surface, and a first smooth layer directly disposed on the first major surface of the substrate. A second smooth layer is directly disposed on the second major surface of the substrate. The first and second smooth layers each have a smooth surface on the side opposite the substrate. A first barrier layer is directly disposed on the smooth surface of the first smooth layer, and a second barrier layer is directly disposed on the smooth surface of the second smooth layer. The first and second smooth layers each include a polymeric matrix material, wherein the polymeric matrix material is at least one of the first and second smooth layers comprises one or more cured thion-ene materials,
wherein at least one of the first and second smooth layers further comprises particles having an average dimension in the range of 2nm to 2micron.

Various unexpected results and advantages are obtained in exemplary embodiments of the disclosure. One such advantage of exemplary embodiments of the present disclosure is that some multilayer barrier films include a smooth layer containing a thiol-ene material as a polymeric matrix material for hosting nanoparticles, and some multilayer barrier films have a sandwich structure, either of which or combination thereof can provide excellent barrier performance

Various aspects and advantages of exemplary embodiments of the disclosure have been summarized. The above Summary is not intended to describe each illustrated embodiment or every implementation of the present certain exemplary embodiments of the present disclosure. The Drawings and the Detailed Description that follow more particularly exemplify certain preferred embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
FIG. 1 is schematic cross-sectional view of a multilayer barrier stack, according to one embodiment,
FIG. 2 is schematic cross-sectional view of a multilayer barrier stack having a sandwich structure, according to another embodiment.

In the drawings, like reference numerals indicate like elements While the above-identified drawings, which may not be drawn to scale, sets forth various embodiments of the present disclosure, other embodiments are also contemplated, as noted in the Detailed Description. In all cases, this disclosure describes the presently disclosed disclosure by way of representation of exemplary embodiments and not by express limitations. It should be understood that numerous other modifications and embodiments can be devised by those skilled in the art, which fall within the scope and spirit of this disclosure.

### DETAILED DESCRIPTION

For the following Glossary of defined terms, these definitions shall be applied for the entire application, unless a different definition is provided in the claims or elsewhere in the specification.

### Glossary

Certain terms are used throughout the description and the claims that, while for the most part are well known, may require some explanation. It should be understood that:
The term "homogeneous" means exhibiting only a single phase of matter when observed at a macroscopic scale.

The terms "(co)polymer" or "(co)polymers" includes homopolymers and copolymers, as well as homopolymers or copolymers that may be formed in a miscible blend, *e.g*., by coextrusion or by reaction, including, e.g., transesterification. The term "copolymer" includes random, block and star (e.g. dendritic) copolymers.

The term "(meth)acrylate" with respect to a monomer, oligomer or means a vinyl-functional alkyl ester formed as the reaction product of an alcohol with an acrylic or a methacrylic acid.

The term "thiol-ene" refers to a curable system including one or more of photopolymerizable multifunctional thiol monomers, multifunctional one monomers (including multifunctional acrylate). The curable system can be cured under air without nitrogen gas protection.

The term "diamond-like glass" (DLG) refers to substantially or completely amorphous glass including carbon and silicon, and optionally including one or more additional components selected from the group including hydrogen, nitrogen, oxygen, fluorine, sulfur, titanium, and copper. Other elements may be present in certain embodiments. The amorphous diamond-like glass films may contain clastering of atoms to give it a short-range order but are essentially void of medium and long range ordering that lead to micro or macro crystallinity which can adversely scatter radiation having wavelengths of from 180 nanometers (nm) to 800 nm.

The term "diamond-like carbon" (DLC) refers to an amorphous film or coating comprising approximately 50 to 90 atomic percent carbon and approximately 10 to 50 atomic percent hydrogen, with a gram atom density of between approximately 0.20 and approximately 0,28 gram atoms per cubic centimeter, and composed of approximately 50% to approximately 90% tetrahedral bonds.

The term "adjoining" with reference to a particular layer means joined with or attached to another layer, in a position wherein the two layers are either next to (i.e., adjacent to) and directly contacting each other, or contiguous with each other but not in direct contact (i.e., there are one or more additional layers intervening between the layers).

By using terms of orientation such as "atop, "on", "over", "covering", "uppermost", "underlying" and the like for the location of various elements in the disclosed coated articles, we refer to the relative position of an element with respect to a horizontally-disposed, upwardly-facing substrate. However, unless otherwise indicated, it is not intended that the substrate or articles should have any particular orientation in space during or after manufacture.

By using the term "overcoated" to describe the position of a layer with respect to a substrate or other element of an article of the present disclosure, we refer to the layer as being atop the substrate or other element, but not necessarily contiguous to either the substrate or the other element.

By using the term "separated by" to describe the position of a layer with respect to other layers, we refer to the layer as being positioned between two other layers but not necessarily contiguous to or adjacent to either layer

The terms "about" or "approximately" with reference to a numerical value or a shape means +/- five percent of the numerical value or properly or characteristic, but expressly includes the exact numerical value. For example, a viscosity of "about" 1 Pa-sec refers to a viscosity from 0.95 to 1.05 Pa-sec, but also expressly includes a viscosity of exactly 1 Pa-sec. Similarly, a perimeter that is "substantially square" is intended to describe a geometric shape having four lateral edges in which each lateral edge has a length which is from 95% to 105% of the length of any other lateral edge, but which also includes a geometric shape in which each lateral edge has exactly the same length

The term "substantially" with reference to a property or characteristic means that the property or characteristic is exhibited to a greater extent than the opposite of that property or characteristic is exhibited. For example, a substrate that is "substantially" transparent refers to a substrate that transmits more radiation (e.g. visible light) than it fails to transmit (e.g. absorbs and reflects). Thus, a substrate that transmits more than 50% of the visible light incident upon its surface is substantially transparent, but a substrate that transmits 50% or less of the visible light incident upon its surface is not substantially transparent

As used in this specification and the appended embodiments, the singular forms "'a", "an", and "the" include plural referents unless the content clearly dictates otherwise. Thus, for example, reference to fine fibers containing "a compound" includes a mixture of two or more compounds. As used in this specification and the appended embodiments, the term "or" is generally employed in its sense including "and/or" unless the content clearly dictates otherwise.

As used in this specification, the recitation of numerical ranges by endpoints includes all numbers subsumed within that range (e.g 1 to 5 includes 1, 1.5, 2, 2.75, 3, 3.8, 4. and 5).

Unless otherwise indicated, all numbers expressing quantities or ingredients, measurement of properties and so forth used in the specification and embodiments are to be understood as being modified in all instances by the term "about." Accordingly, unless indicated to the contrary, the numerical parameters set forth in the foregoing specification and attached listing of embodiments can vary depending upon the desired properties sought to be obtained by those skilled in the art utilizing the teachings of the present disclosure. At the very least, and not as an attempt to limit the application of the doctrine of equivalents to the scope of the claimed embodiments, each numerical parameter should at least be construed in light of the number of reported significant digits and by applying ordinary rounding techniques.

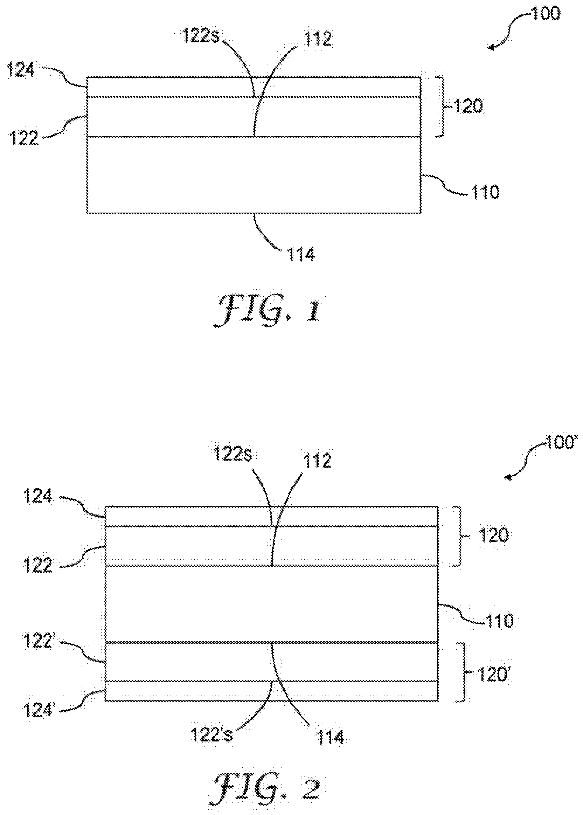

FIG. 1 is a schematic cross-sectional view of a multilayer barrier assembly 100, according to one embodiment The multilayer barrier assembly 100 includes a barrier stack 120 disposed on a flexible substrate 110. In some embodiments, the barrier stack 120 and the flexible substrate 110 may form an integral protective layer. In some embodiments, the barrier stack 120 can be released from the substrate 110 before use. The barrier stack 120 includes a smooth layer 122 and a barrier layer 124 arranged in a layered structure. The flexible substrate has a first major surface 112 and a second major surface 114 opposite the first major surface 112. It is to be understood that the substrate may be rigid or semi-rigid instead of flexible. In the depicted embodiment, the smooth layer 122 is directly disposed on the first major surface 112 of the flexible substrate 110. The smooth layer 122 includes a smooth surface 122s opposite the first major surface 112 of the flexible substrate 110. The barrier layer 124 is directly disposed on the smooth surface 122s.

The smooth layer 122 and the barrier layer 124 can be called a dyad. While only one dyad (i.e., the smooth layer 122 and the barrier layer 124 in FIG. 1) is shown for the barrier stack 120. it is to be understood that the barrier stack 120 may include additional alternating smooth layers and barrier layers disposed on the first major surface 112 of the flexible substrate 110.

It is to be understood that in some embodiments, the flexible substrate 110 may be optional. The barrier stack 120 may be removable from the substrate 110 and applied to any suitable devices. For example, the substrate 110 may include a release coating thereon which allows the barrier stack 120 to be released without any significant damage.

FIG. 2 is a schematic cross-sectional view of a multilayer barrier assembly 100', according to one embodiment. The multilayer barrier assembly 100' has a sandwich structure, including a first barrier stack 120 disposed on the first major surface 112 and a second barrier stack 120' disposed on the second major surface 114. The second barrier stack 120' includes a smooth layer 122' and a barrier layer 124' arranged in a layered structure. In the depicted embodiment, the smooth layers 122 and 122' are directly disposed on the first major surface 112 and the second major surface 114 of the flexible substrate 110, respectively. The smooth layer 122' includes a smooth surface 122's opposite the second major surface 114 of the flexible substrate 110. The barrier layer 124' is directly disposed on the smooth surface 122's.

The substrate 110 can include thermoplastic films such as polyesters (e.g., PET), polyacrylates (e.g., polymethyl methacrylate), polycarbonates, polypropylenes, high or low density polyethylenes, polyethylene naphthalates, polysulfones, polyether sulfones, polyurethanes, polyamides, polyvinyl butyral, polyvinyl chloride, polyvinylidene difluoride and polyethylene sulfide, and thermoset films such as cellulose derivatives, polyimide, polyimide benzoxazole, and poly benzoxazole.

Other suitable materials for the substrate include chlorotrifluoroethylene-vinylidene fluoride copolymer (CTFE/VDF), ethylene-chlorotrifluoroethylene copolymer (ECTFE), ethylene-tetrafluoroethylene copolymer (ETFE), fluorinated ethylene-propylene copolymer (FEP), polychlorotrifluoroethylene (PCTFE), perfluoroalkyl-tetrafluoroethylene copolymer (PFA), polytetrafluoroethylene (PTFE), polyvinylidene fluoride (PVDF), polyvinyl fluoride (PVF), tetrafluoroethylene-hexafluoropropylene copolymer (TFE/HFP), tetrafluoroethylene-hexafluoropropylene-vinylidene fluoride terpolymer (THV), polychlorotrifluoroethylene (PCTFE), hexafluoropropylene-vinylidene fluoride copolymer (HFP/VDF), tetrafluoroethylene-propylene copolymer (TFE/P), and tetrafluoroethylene-perfluotomethylether copolymer (TFP/PFMe).

Alternative substrates include materials having a high glass transition temperature (Tg), preferably being heat-stabilized, using heat setting, annealing under tension, or other techniques that will discourage shrinkage up to at least the beat stabilization temperature when the support is not constrained. If the support has not been heat stabilized, then it preferably has a Tg greater than that of polymethyl methacrylate (PMMA, Tg-105°C.). More preferably the support has a Tg of at least about 110°C., yet more preferably at least about 120°C., and most preferably at least about 128°C. In addition to heat-stabilised polyethylene terephthalate (HSPET). other preferred supports include other heat-stabilized high Tg polyesters. PMMA, styrene/acrylonitrile (SAN, Tg=110°C.), styrene/maleic anhydride (SMA, Tg=115° C.), polyethylene naphthalate (PEN, Tg=about 120° C), polyoxymethylene (POM, Tg=about 125°C.), polyvinylnaphthalene (PVN, Tg=about 135°C.), polyetheretherketone (PEEK, Tg=ahout 145°C). polyaryletherketone (PAEK, Tg=145°C.), high Tg fluoropolymers (e.g., DYNEON™ HTE terpolymer of hexafluoropropylene, tetrafluoroethylene, and ethylene, Tg=about 149°C.). polycarbonate (PC, Tg=about 150° C.). poly alpha-methyl styrene (Tg=about 175°C.), polyarylate (PAR, Tg=190°C.), polysulfone (PSul, Tg=about 195°C.), polyphenylene oxide (PPO, Tg=about 200°C.), polyetherimide (PEI. Tg=about 218°C.), polyarylsulfone (PAS, Tg=220°C.), poly ether sulfone (PES. Tg=about 225° C.), polyamideimide (PAI. Tg=about 275°C.). polyimide (Tg=about 300°C.) and polyphthalamide (heat deflection temp of 120°C.). For applications where material costs are important, supports made of HSPET and PEN are especially preferred. For applications where barrier performance is paramount, supports made of more expense materials may be employed. Preferably the substrate has a thickness of about 0.01 millimeters (mm) to about 1 mm, more preferably about 0.01mm to about 0.25 mm, more preferably about 0.01mm to about 0.1mm, more preferably about 0.01mm to about 0.05mm.

A smooth layer described herein such as smooth layers 122 and 122' can be formed from the same or different crosslinkable polymeric materials as polymeric matrix material. In some embodiments, the smooth layer 122 or 122' can include a curable thiol-ene system which can be cured at air condition without nitrogen gas protection. In some embodiments, the thiol-ene material can include one or more cured thiol-ene resins from polythtol(s) and polyene(s) having a T_{g} > 20°C. The thiol-ene system can include one or more of multifunctional thiol-ene monomers, multifunctional thiol-ene-acrylate monomer, and multifunctional thiol-acrylate monomers that are photo-polymerizable. The smooth layer 122 or 122' of thiol-ene can include one or more polythiol monomers such as, for example, pentacrythritol tetra(3-mercaptopropionate), dipentaerythritol hexa(3-mercaptopropionate), di-pentacrythritolhexakis (3-mercaptoppopinate), di-trimethylolpropanetetra (3-mercaptopropionate), tris[2-(3-mercaptopropionyloxy)ethyl]isocyamurate, ethoxylated trmethylpropan-tri(3-mercapto-propionate), ethoxylated trimethylpropantri( 3-mercapto-propionate), polycaprolactone tetra(3-mercaptopropionate), 2,3-di((2-mercaptoethyl)thio)-1propanethiol, dimercaptodiethylsulfide, trimethylolpropanetri(3-mercapto, glykoldi(3-mercaptopropionate), pentacrythritoltetramercaptoacetate, trimethylolpropanetrimercaptoacetate, and glycoldimercaptoacetate

The thiol-ene material of the smooth layer 122 or 122' can further include one or more polyene monomers selected from polyacrylates, polymethacrylate, polyalkene, polyvinyl ether, polyallyl ether and their combinations. Examples of polyene are triallyl isocyanurate, tri(ethylene glycol) divinyl ether (TEGDVE), pentaerythritol allyl ether(TAE), and 2,4,6-triallyloxy-1,3,5-triazine (TOT), triallyl-1,3,5-triazine-2,4,6(1H,3H,5H)-trione (TTT). Other useful polyene monomers may be derived from the reaction of mono- or polyisocyanate with HX-R(CH=CH2)n, wherein HX is an isocyanate reactive group selected from -OH, -SH and -NH2; R is a multivalent (hetero)hydrocarbyl group; and n is at least 1.

The polyalkene compounds may be prepared as the reaction product of a polythiol compound and an epoxy-alkene compound. Similarly, the polyalkene compound may be prepared by reaction of a polythiol with a di- or higher epoxy compound, followed by reaction with an epoxy-alkene compound. Alternatively, a polyamino compound may be reacted with an epoxy-alkene compound, or a polyamino compound may be reacted a di- or higher epoxy compound, followed by reaction with an epoxy-alkene compound.

The polyalkene may be prepared by reaction of a bis-alkenyl amine, such a HN(CH₂CH=CH₂), with either a di- or higher epoxy compound, or with a bis- or high (meth)acrylate, or a polyisocyanate.

The polyalkene may be prepared by reaction of a hydroxy-functional polyalkenyl compound. such as (CH₂=CH-CH₂-O)ₙ-R-OH with a polyepoxy compound or a polyisocyanate.

An oligomeric polyalkene may be prepared by reaction between a hydroxyalkyl (meth)acrylate and an allyl glycidyl ether.

In some preferred embodiments, the polyalkene and/or the polythiol compounds are oligomeric and prepared by reaction of the two with one in excess. For example, polythiols may be reacted with an excess of polyalkenes (e.g. in mole ratio of 1 to 5) initiated by thermal radical initiator or under photo irradiation such that an oligomeric polyalkene results having a functionality of at least two, as demonstrated below.

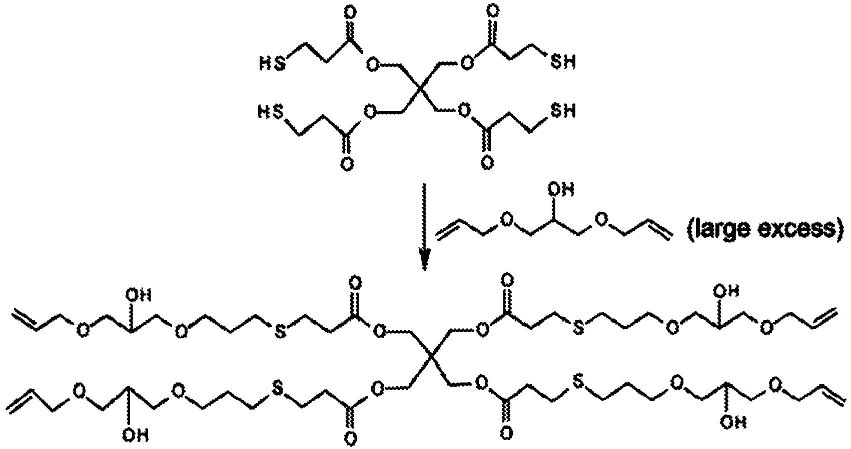

Conversely an excess of polythiols may be reacted with the polyalkenes to form oligomeric polythiol results having a functionality of at least two.

In the following formulas, a linear thiol-alkene polymer is shown for simplicity. It will be understood that the pendent ene group of the first polymer will have reacted with the excess thiol, and the pendent thiol groups of the second polymer will have reacted with the excess alkene.

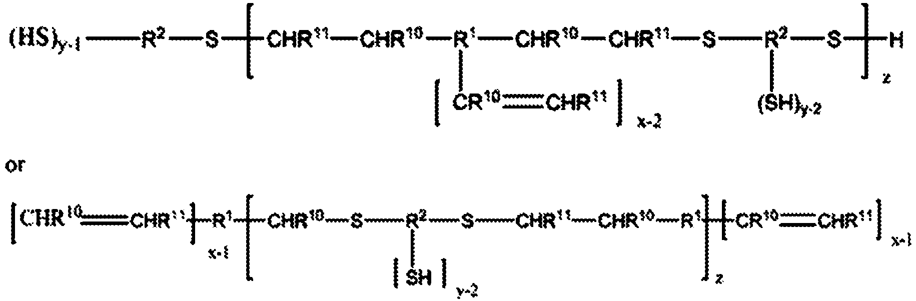

In some embodiments (meth)acrylates are used in the matrix binder composition. In some embodiments, a radiation curable methacrylate compound can increase the viscosity of the matrix composition and can reduce defects that would otherwise be created during the thermal acceleration of the thiol-alkene resin. Useful radiation curable methacrylate compounds have barrier properties to minimize the ingress of water and/or oxygen. In some embodiments, methacrylate compounds with a glass transition temperature (T_{g}) of greater than about 100°C and substituents capable of forming high crosslink densities can provide a matrix with improved gas and water vapor barrier properties. In some embodiments, the radiation curable methacrylate compound is multifunctional, and suitable examples include, but are not limited to, those available under the trade designations SR 348 (ethoxylated (2) bisphenol A di(meth)acrylate), SR540 (ethoxylated (4) bisphenol A di(meth)acrylate), and SR239 (1,6-hexane diol di(meth)acrylate) from Sartomer USA, LLC, Exton, PA.

The (meth)acrylate compound forms about 0 wt% to about 25 wt%, or about 5 wt% to about 25 wt% or about 10 wt% to about 20 wt%, of the matrix composition. In some embodiments, if the methacrylate polymer forms less than 5 wt% of the matrix composition, the (mcth)acrylate compound docs not adequately increase the viscosity of the matrix composition to provide the thiol-alkene composition with a sufficient working time.

The content of the thiol-ene material by weight in a smooth layer can be, for example, in the range from about 10% to about 100%. In some embodiments, the smooth layer can include, for example, about 90 wt% or less, about 80wt% or less, about 70 w% or less, about 60wt% or less, about 50 wt% or less, or about 40wt% or less of the thiol-ene material. The smooth layer can include, for example, about 10 wt% or more, about 30 wt% or more, or about 50 wt% or more of the thiol-ene material.

In some embodiments, a smooth layer described herein such as the smooth layers 122 and 122' can further include one or more crosslinkable acrylate materials such as, for example, pentaerythritol triacrylate, tris(hydroxy ethyl) isocyanurate triacrylate, etc. Especially preferred monomers that can be used to form the smooth layer include urethane acrylates (e.g., CN-968, Tg=about 84° C. and CN-983. Tg=about 90° C.. both commercially available from Sartomer Co.), isobornyl acrylate (e.g, SR-506, commercially available from Sartomer Co., Tg=about 88° C.), dipentaerythritol pentaacrylates (e.g, SR-399, commercially available from Sartomer Co., Tg= about 90° C.), epoxy acrylates blended with styrene (e.g., CN- 120S80, commercially available from Sartomer Co., Tg=about 95° C.), di-trimethylolpropane tetraacrylates (e.g., SR-355, commercially available from Sartomer Co., Tg=about 98° C.), diethylene glycol diacrylates (e.g., SR-230, commercially available from Sartomer Co., Tg=about 100° C), 1,3-butylene glycol diacrylate (e.g., SR-212, commercially available from Sartomer Co., Tg= about 101° C), pentaacrylate esters (e.g.. SR-9041, commercially available from Sartomer Co., Tg=about 102° C.), pentaerythritol tetraacrylates (e.g., SR-295, commercially available from Sartomer Co , Tg=about 103° C.), pentaerythritol triacrylates (e.g., SR-444, commercially available from Sartomer Co., Tg=about 103° C.), ethoxylated (3) trimethylolpropane triacrylates (e.g., SR-454, commercially available from Sartomer Co., Tg=about 103° C.), ethoxylated (3) trimethylolpropane triacrylates (e.g., SR-454HP, commercially available from Sartomer Co., Tg=about 103° C.), alkoxylated trifunctional acrylate esters (e.g., SK-9008, commercially available from Sartomer Co., Tg=about 103° C), dipropylene glycol diacrylates (e.g., SR-508, commercially available from Sartomer Co., Tg=about 104° C.), neopentyl glycol diacrylates (e.g., SR-247, commercially available from Sartomer Co., Tg= about 107° C.), ethoxylated (4) bisphenol a dimethacrylates (e.g., CD-450, commercially available from Sartomer Co., Tg=about 108° C.), cyclohexane dimethamol diacrylate esters (e.g., CD-406, commercially available from Sartomer Co., Tg=about 110° C), isobornyl methacrylate (e.g., SR-423, commercially available from Sartomer Co., Tg=about 110° C.), cyclic diacrylates (e.g., IRR-214, commercially available from UCB Chemicals, Tg=about 208° C.) and tris (2-hydroxy ethyl) isocyanurate triacrylate (e.g., SR-368, commercially available from Sartomer Co.. Tg=about 272° C.), acrylates of the foregoing methacrylates and methacrylates of the foregoing acrylates.

The smooth layer described herein such as the smooth layers 122 and 122' includes particles to improve barrier performance. The particles are hosted by a polymeric matrix material of the smooth layer, e.g., being embedded in the crosslinkable polymeric material thereof. The particles have an average particle diameter in the range, for example, from about 2 nm to about 400 nm. The particles can be single sized nanoparticles or a mixture of different-sized nanoparticles. It is to be understood that the particles have a dimension up to 2 micron. The particles can be inorganic particles. Examples of the inorganic particles include silica, zirconia, titania, alumina, diamond, mixtures thereof, etc. In some embodiments, the smooth layer can include, for example, about 5 wt% or more, about 10 wt% or more, or about 20 wt% or more of the particles, about 30 wt% or more of the particles, about 40 wt% or more of the particles, about 50 wt% or more of the particles, about 60 wt% or more of the particles, or about 70 wt% or more of the particles. It is to be understood that in some embodiments, the particles may be optional and a smooth layer may be formed by polymeric materials without the particles.

In some embodiments, the smooth layer can have a thickness, for example, no less than about 100 nm, no less than about 200 nm, no less than about 500 nm, no less than about one micron, no less than about 2 microns, no less than about 3 microns, no less than about 4 microns, or no less than about 5 microns.

In some embodiments, the smooth layer can be prepared by solution coating on a major surface of a substrate. The smooth layer can be applied using conventional coating methods such as roll coating (e.g., gravure roll coating, or die coating), spray coating (e.g., electrostatic spray coating) or die coating. then crosslinked using, for example, ultraviolet (UV) radiation or thermal curing. A smooth layer coating solution can be formed, for example, by mixing part A (e.g., thiol monomer) and part B (e.g., ene monomers) dissolved in solvents with additives such as, for example, photoinitiator or catalysts. In some embodiments, the smooth layer can be formed by applying a layer of one or more monomers or oligomers and crosslinking the layer to form the polymer in situ, for example, by evaporation and vapor deposition of one or more radiation-crosslinkable monomers cured by, for example, using an electron beam apparatus, UV light source, electrical discharge apparatus or other suitable device. It is to be understood that in some embodiments, the smooth layer may be formed by any suitable processes other than a liquid coating process such as, for example, organic vapor deposition processes.

Optionally, in some embodiments, an intermediate layer can be provided between the smooth layer and the substrate. The intermediate layer can be a primer to improve the adhesion between smooth layer and substrate, and/or can be a moisture and gas barrier layer (e.g., PVDC, EVOH, etc.) to further improve the barrier performance.

A barrier layer described herein such as the barrier layers 124 and 124' of FIGS. 1 and 2 can be formed from a variety of materials. In some embodiments the barrier layer may include a random covalent network containing one or more of carbon and silicon, and one or more of oxygen, nitrogen, hydrogen and fluorine. The barrier layer may further include one or more metals such as, for example, aluminum, zinc, zirconium, titanium, hafnium, etc. In some embodiments, the barrier layer may include one or more of metals, metal oxides, metal nitrides, metal carbides, metal oxynitrides, metal oxycarbide, metal oxyborides, and combinations thereof. Exemplary metal oxides include silicon oxides such as silica, aluminum oxides such as alumina, titanium oxides such as titania, indium oxides, tin oxides, doped tin oxides such as antimony doped tin oxide (ATO), indium tin oxide (ITO), tantalum oxide, zirconium oxide, hafnium oxide, niobium oxide, and combinations thereof. Other exemplary materials include boron carbide, tungsten carbide, silicon carbide, aluminum nitride, silicon nitride, boron nitride, aluminum oxynitride, silicon oxynitride, boron oxynitride, zirconium oxyboride, titanium oxyboride, silicon aluminate, and combinations thereof.

In some embodiments, the barrier layer may include a diamond-like glass (DLO) film. Diamond-like glass (DLG) is an amorphous carbon system including a substantial quantity of silicon and oxygen that exhibits diamond-like properties. In these films, on a hydrogen-free basis, there is at least 30% carbon, a substantial amount of silicon (typically at least 25%) and no more than 45% oxygen. The unique combination of a fairly high amount of silicon with a significant amount of oxygen and a substantial amount of carbon makes these films highly transparent and flexible (unlike glass). Exemplary DLG materials are described in WO 2007/015779 (Padiyath and David), which is incorporated herein by reference.

In creating a diamond-like glass film, various additional components can be incorporated into the basic carbon or carbon and hydrogen composition. These additional components can be used to alter and enhance the properties that the diamond-like glass film imparts to the substrate. For example, it may be desirable to further enhance the barrier and surface properties.

The additional components may include one or more of hydrogen (if not already incorporated), nitrogen, fluorine, sulfur, titanium, or copper. Other additional components may also be of benefit. The addition of hydrogen promotes the formation of tetrahedral bonds. The addition of fluorine is particularly useful in enhancing barrier and surface properties of the diamond-like glass film. The addition of nitrogen may be used to enhance resistance to oxidation and to increase electrical conductivity. The addition of sulfur can enhance adhesion. The addition of titanium tends to enhance adhesion as well as diffusion and barrier properties.

These diamond-like materials may be considered as a form of plasma polymers, which can be deposited on the assembly using. for example, a vapor source. The term "plasma polymer" is applied to a class of materials synthesized from a plasma by using precursor monomers in the gas phase at low temperatures. Precursor molecules are broken down by energetic electrons present in the plasma to form free radical species. These free radical species react at the substrate surface and lead to polymeric thin film growth. Due to the non-specificity of the reaction processes in both the gas phase and the substrate, the resulting polymer films are highly cross-linked and amorphous in nature. This class of materials has been researched and summarized in publications such as the following: H. Yasuda, "Plasma Polymerization," Academic Press Inc., New York (1985); R.d'Agostino (Ed), "Plasma Deposition, Treatment & Etching of Polymers," Academic Press. New York (1990); and H. Biederman and Y. Osada. "Plasma Polymerization Processes," Elsever, New York (1992).

Typically, these polymers have an organic nature to them due to the presence of hydrocarbon and carbonaceous functional groups such as CH₃, CH₂, CH, Si-C, Si-CH₃, Al-C, Si-O-CH₃, etc. The presence of these functional groups may be ascertained by analytical techniques such as IR, nuclear magnetic resonance (NMR) and secondary ion mass (SIMS) spectroscopies. The carbon content in the film may be quantified by electron spectroscopy for chemical analysis (ESCA).

Not all plasma deposition processes lead to plasma polymers. Inorganic thin films are frequently deposited by PECVD at elevated substrate temperatures to produce thin inorganic films such as amorphous silicon, silicon oxide, silicon nitride, aluminum nitride, etc. Lower temperature processes may be used with inorganic precursors such as silane (SiH₄) and ammonia (NH₃). In some cases, the organic component present in the precursors is removed in the plasma by feeding the precursor mixture with an excess flow of oxygen. Silicon rich films are produced frequently from tetramethyldisiloxane (TMDSO)-oxygen mixtures where the oxygen flow rate is ten times that of the TMDSO flow. Films produced in these cases have an oxygen to silicon ratio of about 2, which is near that of silicon dioxide.

The plasma polymer layer of some embodiments in the present disclosure may be differentiated from other inorganic plasma deposited thin films by the oxygen to silicon ratio in the films and by the amount of carbon present in the films. When a surface analytic technique such as ESCA is used for the analysis, the elemental atomic composition of the film may be obtained on a hydrogen-free basis. Plasma polymer films of the present disclosure can be substantially substoichiometric in their inorganic component and substantially carbon-rich, depicting their organic nature. In films containing silicon for example, the oxygen to silicon ratio is preferably below 1.8 (silicon dioxide has a ratio of 2.0), and most preferably below 1.5 as in the case of DLG, and the carbon content is at least about 10%. Preferably, the carbon content is at least about 20% and most preferably at least about 25%. Furthermore, the organic siloxane structure of the films may be detected by IR spectra of the film with the presence of Si-CH₃ groups at 1250 cm⁻¹ and 800 cm⁻¹. and by secondary ion mass spectroscopy (SIMS).

One advantage of DLG coatings or films is their resistance to cracking in comparison to other films. DLG coatings are inherently resistant to cracking either under applied stress or inherent stresses arising from manufacture of the film. The properties of exemplary DLG coatings are described in U.S. Patent No. 8034452 (Padiyath and David) which is incorporated by reference herein .

In some embodiments, the barrier layer may include a diamond-like carbon (DLC) film. Diamond and DLC differ significantly due to the arrangement of carbon atoms in the specific material. Carbon coatings contain substantially two types of carbon-carbon bonds: trigonal graphite bonds (sp²) and tetrahedral diamond bonds (sp³). Diamond is composed of virtually all tetrahedral bonds. DLC is composed of approximately 50% to 90% tetrahedral bonds, and graphite is composed of virtually all trigonal bonds. The crystallinity and the nature of the bonding of the carbon determine the physical and chemical properties of the coating. Diamond is crystalline whereas DLC is a non-crystalline amorphous material, as determined by x-ray diffraction. DLC contains a substantial amount of hydrogen (from 10 to 50 atomic percent), unlike diamond which is essentially pure carbon. Atomic percentages are determined by combustion analysis. Exemplary DLC materials are described in WO 2007/015779 (Padiyath David)

Various additives to the DLC coating can be used. These additives may comprise one or more of nitrogen, oxygen, fluorine, or silicon. The addition of fluorine is particularly useful in enhancing barrier and surface properties of the DLC coating. Sources of fluorine include compounds such as carbon tetrafluoride (CF₄), sulfur hexafluoride (SF₆), C₂ F₆, C₃ F₈, and C₄ F₁₀. The addition of silicon and oxygen to the DLC coating tend to improve the optical transparency and thermal stability of the coating. The addition of nitrogen may be used to enhance resistance to oxidation and to increase electrical conductivity. Sources of oxygen include oxygen gas (O₂), water vapor, ethanol, and hydrogen peroxide. Sources of silicon preferably include silanes such as SiH₄, Si₂ H₆, and hexamethyldisiloxane. Sources of nitrogen include nitrogen gas (N₂), ammonia (NH₃), and hydrazine (N₂ H₆).

In some embodiments, the barrier layer may have a thickness in the range, for example, from about 5 nm to about 5 microns.

In some embodiments, the barrier layer can be formed by a plasma process, eg., a DLG layer formed by an ion-enhanced plasma deposition process. For the deposition of a DLG film, an organosilicon precursor vapor such as hexamcthyldisiloxane (HMDSO) is mixed with oxygen gas, and plasma is generated by using radio frequency (RF), mid-frequency (MF), or microwave (MW) power at a pressure of 0.001 to 0.100 Torr. The precursor vapor, and oxygen gas are dissociated in the plasma, and react at the substrate surface to deposit the thin film, while undergoing intense ion-bombardment. Ion-bombardment is a critical aspect of the deposition process, which densities the depositing thin film, and is achieved by a negative DC self-bias obtained on the smaller powered electrode. The pressure is maintained below 100 mTorr, preferably below 50 mTorr to minimize gas phase nucleation, and to maximize the ion bombardment. It is to be understood that the barrier layer may be formed using any suitable techniques.

In some embodiments, the sandwich structure 100' of FIG. 2 can be formed by sequentially coating the first smooth layer 122 on one side 112 of the substrate 110 and then coating the second smooth layer 122' on the other side 114 of the substrate 110, and sequentially coating the first barrier layer 124 on the first smooth layer 122 and coating the second barrier layer 124' on the second smooth layer 122'. In some embodiments, the sandwich structure 100' can be formed by a 2-trip coating process; one-trip double side coating of smooth layers 122 and 122' on the substrate 110 and followed by one-trip double side coating of the barrier layers 124 and 124' on the top of the respective smooth layers 122 and 122'.

Multilayer barrier films (e.g., a barrier stack such as 120 with or without a substrate such as 110) described herein can be used for various devices including, for example, displays (e.g., including barrier films and quantum dot layer are described in WO 2014/113562 to Nelson, et al LCDs, OLEDs, etc.), solar cells, and other devices that may require higher moisture barrier and anti-scratching performance. The multilayer barrier films can have a water vapor transmission rate (WVTR) no more than about 1, 0.1. or 0.01 g/m²/day at 38° C and 100% relative humidity, less than about 0.05 g/m²/day at 38° C and 100% relative humidity; in some embodiments, less than about 0.005 g/m²/day at 38°C and 100% relative humidity: and in some embodiments, less than about 0.0005 g/m²/day at 38°C and 100% relative humidity. In some embodiments, a barrier stack such as 120 or 120' may have a WVTR of less than about 1, 0.1, 0.05, 0.01, 0.005, 0.0005, or 0.00005 g/m²/day at 50 °C and 100% relative humidity or even less than about 1, 0.1, 0.05, 0.005, 0.0005 g/m²/day at 85 °C and 100% relative humidity. In some embodiments, the multilayer barrier films may have an oxygen transmission rate (OTR) of less than about 0.005 cm³/m²/day at 23°C and 90% relative humidity; in some embodiments, less than about 0.05 or 0.0005 cm³/m³/day at 23 °C and 90% relative humidity; and in some embodiments, less than about 0.00005 cm³/m²/day at 23 °C and 90% relative humidity. The multiplayer barrier films can have an oxygen transmission rate (OTR) less than 0.005, 0.001, 0.0005, 0.0001, or 0.00005 cc/(m²-day-atm) at 23°C and 50% relative humidity. In some embodiments, multilayer barrier films described herein can exhibit superior anti-scratching properties (e.g., having a scratch rating of not greater than I as determined by a linear abrasion test as shown in Table 1 below), and can be resistant to scratching by a cotton abrasion test.

**Table 1. Scratch Rating for Linear Abrasion Test**

| Observation | Rating |
|---|---|
| No scratches | 0 |
| A few very faint scratches only observed in reflection | 1 |
| Several faint scratches | 2 |
| Several faint a few deep scratches | 3 |
| Large number of deep scratches easily observed in reflected or transmitted light. Almost complete removal of coating. | 4 |

The operation of the present disclosure will be further described with regard to the following detailed examples. These examples are offered to further illustrate the various specific and preferred embodiments and techniques. It should be understood, however, that many variations and modifications may be made while remaining within the scope of the present disclosure.

### EXAMPLES

These Examples are merely for illustrative purposes and are not meant to be overly limiting on the scope of the appended claims. Notwithstanding that the numerical ranges and parameters setting forth the broad scope of the present disclosure are approximations the numerical values set forth in the specific examples are reported as precisely as possible. Any numerical value, however, inherently contains certain errors necessarily resulting from the standard deviation found in their respective testing measurements. At the very least, and not as an attempt to limit the application of the doctrine of equivalents to the scope of the claims, each numerical parameter should at least be construed in light of the number of reported significant digits and by applying ordinary rounding techniques.

### Examples A1-A8 and Comparative Examples C1

Examples A1-A8 having a sandwich configuration as shown in FIG. 2 and Comparative Example C1 having a sandwich configuration without a barrier layer (e.g., DLG) on the both side were prepared. Table 1 provides abbreviations and a source for all materials used in the Examples below

### Examples A9-A11 and Comparative Example C2

Examples A9-A11 having a single-side configuration as shown in FIG. 1 and Comparative Example C2 having a single-side configuration without DLG layer on the top of smooth layer were prepared. Table 2 provides abbreviations and a source for all materials used in the Examples below.

### Example C3

Example C3 was prepared by directly deposited a barrier layer (DLG) on one surface of a PET film. The DLG deposition procedure and condition are described in the following "DLG layer coating procedure".

**Table 2**

| **Abbreviation** | **Description** | **Source** |
|---|---|---|
| PET film I | 2 mil PET, one side slip agent coated, the other side primer coated | 3M Company, St. Paul, MN, U.S.A |
| PET film II | 0.5mil PET, double--side PVDC coated | Zhejiang Yibai Packaging Materials Co., Ltd. Zhejiang, China |
| S4 | Pentaerythritol tetra(3-mercaptopropionate) | Bruno Bock, Marschacht. Deutschland |
| S6 | Dipentaerythritol hexa(3-mercaptopropionate) | Bruno Bock, Marschacht, Deutschland |
| S3 | tris[2-(3-mercaptopropionyloxy)ethyl] isocyanurate | Bruno Bock, Marschacht, Deutschland |
| SR344 | Polyethylene glycol (400) Diacrylate | Sartomer Company, Inc., Colombes, France |
| SR444 | Pentaerythritol triacrylate | Sartomer Company, Inc., Colombes, France |
| SR368D | Tris (2-hydroxy ethyl) isocyanurate triacrylate | Sartomer Company, Inc., Colombes, France |
| TAIC | triallyl isocyanurate | TCI Co. Ltd, Tokyo, Japan |
| TPO-L | Ethyl -2,4,6- trimethylbenzoylphenylphosphinate photoinitator | BASF, Ludwigshafen, Germany |
| MEK | Methylethyl Ketone solvent | Aldrich Chemical Company, Milwaukee, W1 |
| A-174 | 3-methacryloxypropyl-trimethoxysilane | Alfa Aesar. Ward Hill, MA. under trade designation "SILQUEST A-174" |
| Axon Hardcoat | Multifunctional acrylate with Silica nanoparticle filled | 3M Company, St. Paul, MN, U.S.A |
| HI Hardcoat | Multifunctional acrylate with ZrO2 nanoparticle filled | 3M Company, St. Paul, MN, U.S.A |
| SiNaps-20 | A-174 modified 20 nm silica in 1-methoxy-2-propanol, 46.7%wt solids | 3M Company, St. Paul, MN |
| HMDSO | Me3Si-O-SiMe3 | Gelest, Morrisville, PA |

### Smooth Layer Coating Solution Preparation 1:

### A part:

Into a 200ml jar added 22.91g S6 and 68.74g MEK/1-methoxy-2-propanol (40:60 weight ratio), and then shaked for a solution with 25% solid by weight.

### B part:

Into 200ml jar put 14.59g TAIC and 43.77g MEK/1-methoxy-2-propanol (40:60 weight ratio), and shake to let it dissolve and then add 0.375g TPO-L (1 wt% with respect to total solid) to get solid of 25% by weight.

### Smooth Layer Coating Solution Preparation 2:

### A part:

Into 200ml jar put 14.90g S6 and 44.7g MEK/1-methoxy-2-propanol (40:60 weight ratio), and then shake to let it dissolve to get solid of 25%wt.

### B part:

Into 200ml jar put 9.47g TAIC and 52.83g MEK/1-methoxy-2-propanol, (40:60 weight ratio), and shake to let it dissolved, and add 28.10g SiNaps-20 and 0.375g TPO-L (1%wt as total solid) to get solid of 23%wt and the weight ratio of 35.65 of particle : monomer.

### Smooth Layer Coating Procedure 1:

Before coating, the pan A was mixed with part B (mole ratio: 1:1) made in the Smooth Layer Coating Solution Preparation 1. And then the smooth layer coating solution was coated at a web speed of 10ft/min on a 9 inch wide, 2.0 mil PET using a slot-die coster. The coating was dried in-line at 70 °C and cured under a nitrogen atmosphere with UV lamp (Fusion H bulb, 300watt, 100% power).

### DLG Layer Coating Procedure:

Load Smooth Layer Coating Procedure 1 EX1 coated samples into vacuum chamber of the coating system used to make DLG coating shown in U.S. Pat. No. 5888594 and pumped down to approximate tens mTorrs. The reactive gases of hexamethyldisiloxane (HMDSO) and O₂ were introduced into the chamber and RF power was applied to the drum. The web speed was adjusted to achieve the desired coating thickness. DLG coating condition: HMDSO:O₂=155 std. cm³/min :660 std. cm³/min; line speed: 10feet/min; and power: 8500 watt.

### WVTR test:

Water vapor transmission rate (WVTR) test was conducted by Mocon Permatran 700 device, commercially available from Mocon Inc., Minneapolis, MN, at 50°C/100%RH, unit: g/(m²-day).

### OTR test:

Oxygen transmission tate (OTR) test was conducted by Mocon OX-TRAN 2/21 device, commercially available from Mocon Inc., Minneapolis, MN, at 23°C/50RH%. unit: cc/(m²-day-atm). The results of WVTR and OTR tests for Examples A1-A11 are shown in Table 3 below.

**Table 3**

| | Substrate | Smooth layer chemistry | Silica size | Silica:monomer (by weight) | WVTR | OTR |
|---|---|---|---|---|---|---|
| Example A1 | PET film I | S4/TAIC | -- | -- | 0.78 | -- |
| Example A2 | PET film I | S4/TAIC/ SiNaps-20 | 20nm | 35:65 | 0.23 | -- |
| Example A3 | PET film I | S6/TAIC | -- | -- | 0.11 | -- |
| Example A4 | PET film I | S6/TAIC/ SiNaps-20 | 20nm | 35:65 | 0.011 | -- |
| Example A 5 | PET film I | S6/TAIC/ SiNaps-20 | 20nm | 60:40 | <0.003 | <0.0005 |
| Example A6 | PET film I | SR444/SR344/ SiNaps-20 | 20nm | 35:65 | 0.007 | -- |
| Example A7 | PET film I | SR368D/ SiNaps-20 | 20nm | 70:30 | 0.007 | <0.0005 |
| Example A8 | PET film II | Axon hardcoat | | | 0.008 | -- |
| Example A9 | PET film I | Axon Hardcoat/10 wt% S3 | | | 0.020 | -- |
| Example A10 | PET film I | HI handcoat/10 wt% S3 | | | 0.028 | -- |
| Example A11 | PET film II | Axon hardcoat | | | 0.38 | |
| Example C1 | | S6/TAIC | -- | -- | >10 | |
| Example C2 | | Axon Hardcoat/10 wt% S3 | | | >10 | -- |

| | | | | | | |
|---|---|---|---|---|---|---|
| Notes: 1) A1-A8 barrier configuration: + 2-dyad Sandwich structure of Barrier layer/Smooth layer/PET/Smooth layer/Barrier layer + Smooth layer thickness: 2 microns/each side + Barrier layer (DLG) condition is described in the "DLG layer coating procedure" 2) A9-A11 barrier configuration: + 1-dyad single-side structure of PET/Smooth layer/Barrier layer + Smooth layer thickness: 2 microns + Barrier layer (DLG) condition is described in the "DLG layer coating procedure" | | | | | | |

### Cotton abrasion test:

The scratch resistance of the samples prepared according to the Examples and Comparative Examples was evaluated by the surface changes after the cotton abrasion test using 10mm^{∗}10mm square 3-layer cotton after 10 cycles at 24.0N load and at 60 cycles/min rate. The strokes were 85 mm long. The instrument used for the test was an abrasion tester (obtained under the trade designation "Genuine Taber, 5900 Reciprocating Abraser." from Taber Industries). After the cotton abrasion test was completed, the samples were observed for the presence of scratches and their optical properties (percent transmittance, haze, and 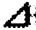 laze (i.e., haze after abrasion test-initial haze) were measured using the instrument "BYK Hazeguard plus" from BYK) listed in Table 4.

**Table 4**

| Sample no. | Side | Before abrasion | | After abrasion | | ΔHaze | WVTR after abrasion |
|---|---|---|---|---|---|---|---|
| | | Transmission % | haze | Transmission % | haze | | |
| Example A4 | inner | 73.6 | 0.58 | 73.9 | 0.75 | 0.17 | - |
| | outer | 74.3 | 0.63 | 73.8 | 0.85 | 0.22 | |
| Example A5 | inner | 75.1 | 0.70 | 75.8 | 0.77 | 0.07 | - |
| | outer | 75.9 | 0.60 | 75.8 | 0.68 | 0.08 | |
| Example A6 | Inner | 90.6 | 0.55 | 90.5 | 0.56 | 0.01 | 0.056 |
| | Outer | 90.6 | 0.60 | 90.5 | 0.60 | 0.00 | |
| Example A77 | Inner | 89.7 | 0.64 | 89.5 | 0.72 | 0.08 | - |
| | Outer | 89.1 | | 89.6 | | 0.12 | |
| Examples C3 | Inner | 90.9 | 1.33 | 90.9 | 1.72 | 0.39 | - |
| | outer | 90.9 | 1.35 | 91.0 | 1.60 | 0.25 | |

Reference throughout this specification to "one embodiment," "certain embodiments," "one or more embodiments" or "an embodiment," whether or not including the term "exemplary" preceding the term "embodiment," means that a particular feature, structure, material, or characteristic described in connection with the embodiment is included in at least one embodiment of the certain exemplary embodiments of the present disclosure. Thus, the appearances of the phrases such as "in one or more embodiments," "in certain embodiments," "in one embodiment" or "in an embodiment" in various places throughout this specification are not necessarily referring to the same embodiment of the certain exemplary embodiments of the present disclosure. Furthennore, the particular features, structures, materials, or characteristics may be combined in any suitable manner in one or more embodiments

While the specification has described in detail certain exemplary embodiments, it will be appreciated that those skilled in the art, upon attaining an understanding of the foregoing, may readily conceive of alterations to variations of, and equivalents to these embodiments. Accordingly, it should be understood that this disclosure is not to be unduly limited to the illustrative embodiments set forth hereinabove. In particular, as used herein, the recitation of numerical ranges by endpoints is intended to include all numbers subsumed within that range (e.g., 1 to 5 includes 1, 1.5, 2, 2.75, 3, 3.80, 4, and 5). In addition, all numbers used herein are assumed to be modified by the term "about"

Furthermore, all publications and patents referenced herein are incorporated by reference in their entirety to the same extent as if each individual publication or patent was specifically and individually indicated to be incorporated by reference. Various exemplary embodiments have been described. These and other embodiments are within the scope of the following claims.

## Claims

1. A multilayer barrier film, comprising:
a smooth layer having a major surface; and
a barrier layer directly disposed on the major surface of the smooth layer,
wherein the smooth layer comprises a thiol-ene material as a polymeric matrix material,
wherein the smooth layer further comprises particles having an average dimension in the range from 2 nm to 2 micron hosted by the polymeric matrix material, and
wherein the thiol-ene material is formed by curing one or more polythiol monomers with one or more polyene monomers.

2. The multilayer barrier film of claim 1, wherein the smooth layer has a thickness no less than about one micron.

3. The multilayer barrier film of claim 1, wherein the barrier layer comprises a random covalent network containing one or more of carbon and silicon, and one or more of oxygen, nitrogen, hydrogen and fluorine.

4. The multilayer barrier film of claim 1, wherein the barrier layer is a layer of diamond-like glass (DLG) material.

5. The multilayer barrier film of claim 1, wherein the smooth layer further comprises one or more acrylate enes.

6. A multilayer barrier film comprising:
a substrate having a first major surface, and a second major surface opposite the first major surface;
a first smooth layer directly disposed on the first major surface of the substrate, a second smooth layer directly disposed on the second major surface of the substrate, the first and second smooth layers each having a major surface on the side opposite the substrate; and
a first barrier layer directly disposed on the major surface of the first smooth layer, and a second barrier layer directly disposed on the major surface of the second smooth layer,
wherein the first and second smooth layers each comprises a polymeric matrix material,
wherein the polymeric matrix material in at least one of the first and second smooth layers comprises one or more cured thiol-ene materials,
wherein at least one of the first and second smooth layers further comprises particles having an average dimension in the range from 2 nm to 2 micron hosted by the polymeric matrix material, and
wherein the thiol-ene material(s) is formed by curing one or more polythiol monomers with one or more polyene monomers.

7. The multilayer barrier film of claim 6, wherein at least one of the first and second barrier layers comprises a random covalent network containing one or more of carbon and silicon, and one or more of oxygen, nitrogen, hydrogen and fluorine.

8. The multilayer barrier film of claim 6, wherein at least one of the first and second barrier layers is a layer of diamond-like glass (DLG) material.

## Patentansprüche

1. Mehrschichtige Sperrfolie, umfassend:
eine glatte Schicht mit einer Hauptoberfläche; und
eine Sperrschicht, die direkt auf der Hauptoberfläche der glatten Schicht angeordnet ist,
wobei die glatte Schicht ein Thiol-en-Material als Polymermatrixmaterial umfasst,
wobei die glatte Schicht ferner Teilchen mit einer durchschnittlichen Abmessung im Bereich von 2 nm bis 2 Mikrometer umfasst, die von dem Polymermatrixmaterial beherbergt werden, und
wobei das Thiol-en-Material durch Härten eines oder mehrerer Polythiol-Monomere mit einem oder mehreren Polyen-Monomeren gebildet wird.

2. Mehrschichtige Sperrfolie nach Anspruch 1, wobei die glatte Schicht eine Dicke von nicht weniger als etwa einen Mikrometer aufweist.

3. Mehrschichtige Sperrfolie nach Anspruch 1, wobei die Sperrschicht ein zufälliges kovalentes Netzwerk umfasst, das einen oder mehrere von Kohlenstoff und Silicium und eines oder mehrere von Sauerstoff, Stickstoff, Wasserstoff und Fluor enthält.

4. Mehrschichtige Sperrfolie nach Anspruch 1, wobei die Sperrschicht eine Schicht aus diamantähnlichem Glasmaterial (DLG-Material) ist.

5. Mehrschichtige Sperrfolie nach Anspruch 1, wobei die glatte Schicht ferner eines oder mehrere Acrylat-ene umfasst.

6. Mehrschichtige Sperrfolie, umfassend:
ein Substrat mit einer ersten Hauptoberfläche und einer zweiten, der ersten Hauptoberfläche gegenüberliegenden Hauptoberfläche;
eine erste glatte Schicht, die direkt auf der ersten Hauptoberfläche des Substrats angeordnet ist, eine zweite glatte Schicht, die direkt auf der zweiten Hauptoberfläche des Substrats angeordnet ist, wobei die erste und die zweite glatte Schicht jeweils eine Hauptoberfläche auf der dem Substrat gegenüberliegenden Seite aufweisen; und
eine erste Sperrschicht, die direkt auf der Hauptoberfläche der ersten glatten Schicht angeordnet ist, und eine zweite Sperrschicht, die direkt auf der Hauptoberfläche der zweiten glatten Schicht angeordnet ist,
wobei die erste und die zweite glatte Schicht jeweils ein Polymermatrixmaterial umfassen,
wobei das Polymermatrixmaterial in mindestens einer von der ersten und der zweiten glatten Schicht eines oder mehrere gehärtete Thiol-en-Materialien umfasst,
wobei mindestens eine von der ersten und der zweiten glatten Schicht ferner Partikel umfasst, die eine durchschnittliche Abmessung im Bereich von 2 nm bis 2 Mikrometer aufweisen und die von dem Polymermatrixmaterial beherbergt werden, und
wobei das (die) Thiol-en-Material(ien) durch Härten eines oder mehrerer Polythiol-Monomere mit einem oder mehreren Polyen-Monomeren gebildet wird (werden).

7. Mehrschichtige Sperrfolie nach Anspruch 6, wobei mindestens eine von der ersten und der zweiten Sperrschicht ein zufälliges kovalentes Netzwerk umfasst, das Kohlenstoff und/oder Silicium und einen oder mehrere von Sauerstoff, Stickstoff, Wasserstoff und Fluor enthält.

8. Mehrschichtige Sperrfolie nach Anspruch 6, wobei mindestens eine von der ersten und der zweiten Barriereschicht eine Schicht aus diamantartigem Glasmaterial (DLG-Material) ist.

## Revendications

1. Film barrière multicouche, comprenant :
une couche lisse ayant une surface principale ; et
une couche barrière disposée directement sur la surface principale de la couche lisse,
dans lequel la couche lisse comprend un matériau de thiol-ène en tant que matériau de matrice polymère.
dans lequel la couche lisse comprend en outre des particules ayant une dimension moyenne dans la plage de 2 nm à 2 micromètres hébergée par le matériau de matrice polymère, et
dans lequel le matériau de thiol-ène est formé en durcissant un ou plusieurs monomères de polythiol avec un ou plusieurs monomères de polyène.

2. Film barrière multicouche selon la revendication 1, dans lequel la couche lisse a une épaisseur non inférieure à environ un micromètre.

3. Film barrière multicouche selon la revendication 1, dans lequel la couche barrière comprend un réseau covalent aléatoire contenant un ou plusieurs parmi le carbone et le silicium, et un ou plusieurs parmi l'oxygène, l'azote, l'hydrogène et le fluor.

4. Film barrière multicouche selon la revendication 1, dans lequel la couche barrière est une couche de matériau de verre de type diamant (DLG).

5. Film barrière multicouche selon la revendication 1, dans lequel la couche lisse comprend en outre un ou plusieurs acrylate-ènes.

6. Film barrière multicouche comprenant :
un substrat ayant une première surface principale, et une deuxième surface principale opposée à la première surface principale, et
une première couche lisse disposée directement sur la première surface principale du substrat, une deuxième couche lisse disposée directement sur la deuxième surface principale du substrat, les première et deuxième couches lisses ayant chacune une surface principale sur le côté opposé au substrat ; et
une première couche barrière disposée directement sur la surface principale de la première couche lisse, et une deuxième couche barrière disposée directement sur la surface principale de la deuxième couche lisse,
dans lequel les première et deuxième couches lisses comprennent chacune un matériau de matrice polymère.
dans lequel le matériau de matrice polymère dans au moins l'une des première et deuxième couches lisses comprend un ou plusieurs matériaux thiol-ène durcis.
dans lequel au moins l'une des première et deuxième couches lisses comprend en outre des particules ayant une dimension moyenne dans la plage de 2 nm à 2 micromètres hébergée par le matériau de matrice polymère, et
dans lequel le ou les matériau(x) thiol-ène est formé par durcissement d'un ou plusieurs monomères de polythiol avec un ou plusieurs monomères polyène.

7. Film barrière multicouche selon la revendication 6, dans lequel au moins l'une des première et deuxième couches barrières comprend un réseau covalent aléatoire contenant un ou plusieurs parmi le carbone et le silicium, et un ou plusieurs parmi l'oxygène, l'azote, l'hydrogène et le fluor.

8. Film barrière multicouche selon la revendication 6, dans lequel au moins l'une des première et deuxième couches barrières est une couche de matériau de verre de type diamant (DLG).
